# EUROPÄISCHE PATENTSCHRIFT

(11) **EP 1 119 859 B1**
(45) Veröffentlichungstag und Bekanntmachung des Hinweises auf die Patenterteilung: **04.12.2002**
(21) Anmeldenummer: 99955821.6
(22) Anmeldetag: 30.09.1999
(51) Int. Cl.: G11C 8/00

(54) **DUAL-PORT SPEICHERZELLE**
DUAL-PORT MEMORY LOCATION
CELLULE MEMOIRE A DOUBLE ACCES

(30) Priorität: 30.09.1998 DE 19845053
(43) Veröffentlichungstag der Anmeldung: 01.08.2001
(73) Patentinhaber: SIEMENS AKTIENGESELLSCHAFT, 80333 München (DE)
(72) Erfinder: RAJ, Kumar, Jain, 349249 Singapur (SG); EHRENTRAUT, Herbert, D-85072 Eichstätt (DE)
(74) Vertreter: Reinhard - Skuhra - Weise & Partner
(86) Internationale Anmeldenummer: DE9903151
(87) Internationale Veröffentlichungsnummer: WO00019437

(56) Entgegenhaltungen:
- US-A- 5 007 022
- US-A- 5 010 519
- US-A- 5 327 375
- US-A- 5 923 593

## Beschreibung

Die Erfindung betrifft eine Dual-Port Speicherzelle gemäß dem Oberbegriff des Anspruchs 1, wie aus der US-A-5,010,519, oder aus der US-A-4,292,677 bekannt.

Die Erfindung betrifft ebenfalls einen DRAM-Halbleiterspeicher mit Dual-Port Speicherzellen.

Als Dual-Port Speicherzellen werden alle Speicherzellen bezeichnet, die genau zwei Datenleitungen aufweisen. Eine als statische Speicherzelle ausgebildete Dual-Port Speicherzelle (static random access memory; SRAM) enthält typischerweise acht Transistoren, jeweils vier Auswahltransistoren (Transfer-Gates) und vier Speichertransistoren (Inverter). Diese Transistoren sind jeweils mit zwei Wortleitungen (Auswahlleitungen) und mit zwei Bitleitungen (Datenleitungen) verbunden. Dynamische Dual-Port Speicherzellen (dynamic random access memory; DRAM) sind bislang nicht bekannt.

Künftige mikroelektronische Schaltungen werden komplizierte Speicherarchitekturen mit Transistorenzahlen im Bereich von 10¹² bis 10¹⁵ realisieren. Eine aus ökonomischen Gründen elementare Randbedingung kommt hier ohne Zweifel einem möglichst geringen Flächenaufwand jeder der Speicherzellen auf dem Halbleiterchip zu. Die Gesamtzahl der Transistoren einer einzelnen Speicherzelle sowie deren Verdrahtungsaufwand, bei dem vorgegebenen "Design-Rules" beachtet werden müssen, bestimmt im wesentlichen die Größe der Speicherzelle und somit den Flächenaufwand des aus einer Vielzahl von derartigen Speicherzellen aufgebauten Halbleiterspeichers.

Eine weitere sehr wichtige Randbedingung, die insbesondere für den die Speicherzellen enthaltenden Halbleiterspeicher eine sehr wichtige Rolle spielt, ergibt sich aus der Forderung einer möglichst geringen Zugriffszeit auf die einzelnen Speicherzellen des Halbleiterspeichers. Die Verkürzung der effektiven Zugriffszeit ist insbesondere bei den im Prinzip sehr langsamen, dynamischen Speichern (DRAMs) sehr wichtig, um keinen zu großen Unterschied in Bezug auf die Taktraten der heute standardmäßig eingesetzten Prozessoren entstehen zu lassen. Die Zugriffszeit bei einem Halbleiterspeicher ergibt sich im wesentlichen aus der Laufzeit der Datensignale auf den Wortleitungen und aus der Umladung der Speicherkapazitäten. Da jedoch bei einem Übergang eines Halbleiterspeichers von 1-Port-Speicherzellen auf 2-Port-Speicherzellen die effektive Leiterbahnlänge um etwa 40% zunimmt, ergibt sich unerwünschterweise eine entsprechende Zunahme der Signallaufzeiten und somit eine Zunahme der Zugriffszeiten. Aufgrund der dadurch verursachten zusätzlichen parasitären Kapazitäten und Widerstände in den Wortleitungen und Datenleitungen vergrößern sich die Signalwechselzeiten und somit die Zugriffszeiten auf den einzelnen Speicherzellen erheblich.

Der vorliegenden Erfindung liegt daher die Aufgabe zu Grund, eine dynamische Dual-Port Speicherzelle mit einem platzsparendem Design anzugeben.

Erfindungsgemäß wird diese Aufgabe durch eine Dual-Port-Speicherzelle mit den Merkmalen des Patentanspruchs 1 gelöst.

Die erfindungsgemäße Dual-Port-Speicherzelle weist in der bevorzugten Ausgestaltung jeweils ein als Speichertransistor ausgebildetes kapazitives Element und zwei Auswahltransistoren auf, deren Laststrecken in Reihe geschalten sind und diese Reihenschaltung zwischen zwei Datenleitungen angeordnet ist. Durch diese Anordnung kann eine Dual-Port-Speicherzelle parallel von zwei Datenverarbeitungseinheiten ausgelesen und beschrieben werden.

Es wäre selbstverständlich auch denkbar das kapazitive Element als zwei miteinander kurzgeschlossenen Kondensatoren, die jeweils zwischen dem Mittelabgriff der Auswahltransistoren und einem Bezugspotential angeordnet sind, zu realisieren. DRAM-Speicherzellen sind insbesondere aufgrund deren verhältnismäßig kleinen Kapazitäten und geringen effektiven Leitungslängen bei dynamischen Halbleiterspeichern besonders vorteilhaft, da hier die entsprechenden Speicherzellen sehr klein dimensioniert werden können.

Der entscheidende Vorteil der erfindungsgemäßen Dual-Port Speicherzellen in einer DRAM-Speicherarchitektur liegt, wie bereits erwähnt, in einem flächenoptimierten Design, das heißt in der Möglichkeit eine Speicherarchitektur mit deutlich reduziertem Flächenaufwand bereitzustellen. Insbesondere, wenn das kapazitive Element als CMOS-Transistor ausgebildet ist, kann jeder der Laststreckenanschlüsse des CMOS-Transistors mit jeweils einem Laststreckenanschluß der Auswahltransistoren kurzgeschlossen sein. Besonders vorteilhaft ist es dabei, wenn die Anschlußknoten der CMOS-Transistoren mit den Anschlußknoten der Auswahltransistoren zusammenfallen. Durch diese Einsparung von flächenintensiven Anschlußknoten kommt die erfindungsgemäße Dual-Port-Speicherzelle mit einem sehr niederigen Flächenbedarf aus, wodurch sich mithin Dual-Port DRAM-Speicherzellen besonders kostengünstig herstellen lassen. Die Einsparung von Anschlußknoten läßt sich jedoch auch bei als Kondenstoren ausgebildeten kapaziten Elementen vorteilhaft realisieren.

Bei der erfindungsgemäße Speicherzelle weisen beide Ausgangspfade des kapazitiven Elementes ein definiertes, annähernd gleich großes Potential auf. Eine derartige Funktionalität konnte bei herkömmlichen DRAM-Speicherzellen DPS bislang nicht gewährleistet werden, da hier jeweils ein Anschluß des kapazitiven Elementes immer "floatet", d. h. auf einem undefinierten Potential liegt. DRAM-Speicherzellen mußten daher in regelmäßigen Abständen wiederaufgeladen werden (Refresh-Vorgang). Während dieses Refresh-Vorganges konnte die DRAM-Speicherzelle nicht ausgelesen oder beschrieben werden, wodurch sich undefinierte Schaltzustände nie ganz vermeiden lassen. Diese oben genannte Funktionalität konnte daher bislang nur von SRAM-Speicherzellen erzielt werden. Durch die erfindungsgemäße Dual-Port-DRAM-Speicherzelle lassen sich die oben beschriebenen Vorteile einer DRAM-Speicherzelle, d. h. kürzere Zugriffszeit, Flächenoptimierung, etc., mit der Funktionalität einer SRAM-Speicherzelle in Bezug auf dessen definierten Schaltzustände verknüpfen.

Die erfindungsgemäße Speicherzelle ist aufgrund ihres Designs, d. h. aufgrund der geringen Anzahl der Schaltungselemente und niedrigen Leiterbahnlängen, überdies sehr rauschunempfindlich. Die Speicherzelle zeigt daher ein verdeutlich verbessertes Signal-Rausch-Verhältnis (Signal Noise Ratio; SNR) im Vergleich zu herkömmlichen Dual-Port-Speicherzellen.

Die geringere Anzahl der Transistoren und die geringen effektiven Leiterbahnlängen bewirkt außerdem sehr niedrige Zugriffszeiten. Aufgrund der verringerten parasitären Kapazitäten und Widerstände im kritischen Leitungspfad wird die Zugriffszeit überdies noch verbessert. Dadurch lassen sich Speichersysteme bereitstellen, die bei gleicher Taktfrequenz eine höhere Leistungsfähigkeit aufweisen.

Insbesondere eignet sich die Erfindung besonders vorteilhaft bei sogenannten Multi-Port-Halbleiterspeichern, die eine Vielzahl von erfindungsgemäßen Dual-Port DRAM-Speicherzellen aufweisen.

Die Unteransprüche sind auf bevorzugte Ausgestaltungen und Weiterbildungen der Erfindung gerichtet.

Die Erfindung wird nachfolgend anhand der in den Figuren der Zeichnung angegebenen Ausführungsbeispiele näher erläutert. Es zeigt dabei:
- Figur 1: das Schaltbild eines ersten Ausführungsbeispiels einer erfindungsgemäßen Dual-Port-Speicherzelle;
- Figur 2: das Schaltbild eines zweiten Ausführungsbeispiels einer erfindungsgemäßen Dual-Port-Speicherzelle;
- Figur 3: ein vorteilhaftes Ausführungsbeispiel eines DRAM-Halbleiterspeichers mit erfindungsgemäßen Dual-Port-Speicherzellen.

In allen Figuren der Zeichnung sind gleiche oder funktionsgleiche Elemente, sofern dies nicht anders angegeben ist, mit gleichen Bezugszeichen versehen. Nachfolgend werden alle Dual-Port DRAM-Speicherzellen, sofern nichts anderes angegeben ist, kurz als Speicherzellen bezeichnet.

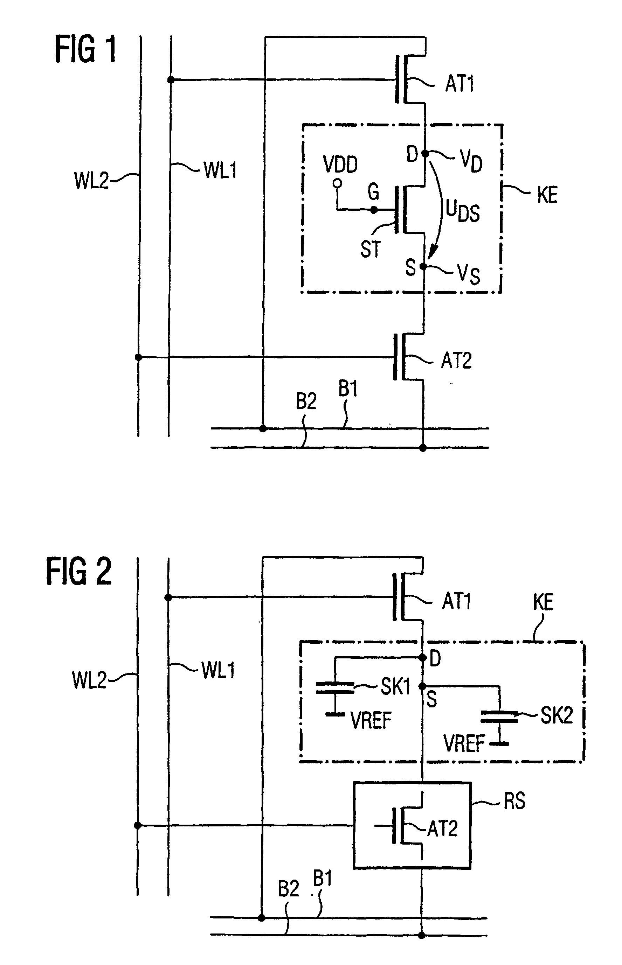

Figur 1 zeigt das Schaltbild eines ersten Ausführungsbeispiels einer erfindungsgemäßen Dual-Port DRAM-Speicherzelle DPS. Die Speicherzelle DPS weist zwei Auswahltransistoren AT1, AT2 sowie ein kapazitives Element KE auf. In Figur 1 ist das kapazitive Element KE als CMOS-Speichertransistor ST, dessen Gateanschluß G mit einem Versorgungspotential VDD verbunden ist, ausgebildet. Der Drainanschluß D des Speichertransistors ST ist über die Laststrecke des ersten Auswahltransistors AT1 mit einer erste Datenleitung B1 verbunden. Der Sourceanschluß S des Speichertransistors ST ist über die Laststrecke des zweiten Auswahltransistors AT2 mit einer zweiten Datenleitung B2 verbunden. Die Laststrecken der Auswahltransistoren AT1, AT2 sowie des Speichertransistors ST sind somit in Reihe geschaltet und zwischen der ersten Datenleitung B1 und der zweiten Datenleitung B2 angeordnet. Die Steueranschlüsse der Auswahltransistoren AT1, AT2 sind mit jeweils einer Wortleitung WL1, WL2 verbunden. Über ein Auswahlsignal auf den Wortleitungen WL1, WL2 sind die entsprechenden Auswahltransistoren AT1, AT2 getrennt und unabhängig ansteuerbar.

Die Speicherzelle DPS ist über die Datenleitungen B1, B2 mit zwei nachgeschalteten Datenverarbeitungseinheiten verbunden. Diese Datenverarbeitungseinheiten können beispielsweise als Mikrocomputer, Prozessor, Logikschaltung, Bus, etc. ausgebildet sein. Typischerweise, jedoch nicht notwendigerweise, werden die Datenverarbeitungseinheiten mit unterschiedlichen Taktfrequenzen betrieben. Über die Datenleitungen B1, B2 lassen sich unabhängig voneinander bidirektionell Daten aus der Speicherzelle DPS, d. h. aus dem Speichertransistor ST, einlesen und auslesen. Über die Wortleitungen WL1, WL2 lassen sich die entsprechenden Auswahltransistoren AT1, AT2 in den leitenden Zustand bzw. in einen gesperrten Zustand steuern.

Figur 2 zeigt das Schaltbild eines zweiten Ausführungsbeispiels einer erfindungsgemäßen Dual-Port-Speicherzelle. Bei der Speicherzelle DPS in Figur 2 wurde das kapazitive Element KE mittels zweier parallel angeordneter Speicherkondensatoren SK1, SK2 realisiert. Die Speicherkondensatoren SK1, SK2 sind als DRAM-Kondensatoren ausgebildet, die jeweils mit ihren ersten Kondensatoranschlüssen (Kondensatorplatten) miteinander und jeweils mit einem Laststreckenanschluß der Auswahltransistoren AT1, AT2 verbunden sind. Die jeweils zweiten Kondensatoranschlüsse sind ("floatend") mit einem Versorgungspotential VREF beaufschlagt. Besonders vorteilhaft ist es, wenn die ersten Kondensatoranschlüsse mit den jeweiligen Laststreckenanschlüssen der zugeordneten Auswahltransistoren AT1, AT2 zur Gewährleistung eines flächenoptimierten Designs zusammenfallen.

Zusätzlich kann eine Logikschaltung bzw. eine Zustandsmaschine vorgesehen sein, die den gespeicherten Dateninhalt der Speicherzelle DPS regelmäßig wiederauflädt. Eine derartige Logikschaltung bzw. Zustandsmaschine wird im Fachjargon als Refresh-Schaltung RS bezeichnet. Diese Refresh-Schaltung RS enthält im vorliegenden Ausführungsbeispiel den zweiten Auswahltransistor AT2. Im vorliegenden Ausführungsbeispiel ist lediglich zwischen dem kapazitiven Element KE und der zweiten Datenleitung B2 eine solche Refresh-Schaltung RS vorgesehen. Es wäre selbstverständlich auch denkbar, zusätzlich oder alternativ eine (weitere) Refresh-Schaltung zwischen der ersten Datenleitung B1 und dem kapazitiven Element KE vorzusehen.

Die Refresh-Schaltung RS kann in bekannter Weise durch zwei Leseverstärker und eine Voraufladeschaltung gebildet werden. Diese zwei Leseverstärker und die Voraufladeschaltung könnten Bestandteil des Bitleitungsdekoders des Halbleiterspeichers sein.

Besonders vorteilhaft ist es, wenn eine sogenannte Autorefresh-Schaltung RS vorgesehen ist, bei der das Wiederaufladen der Speicherzelle DPS automatisiert ist. Über einen einfachen taktgesteuert Ringzähler lassen sich fortwährend in auf- oder absteigender Folge die einzelnen Adressen der verschiedenen Speicherzellen generieren, die dann in den entsprechenden Zeitabständen durch die Voraufladeschaltung oder durch eine Referenzspannungsquelle wiederaufgeladen werden.

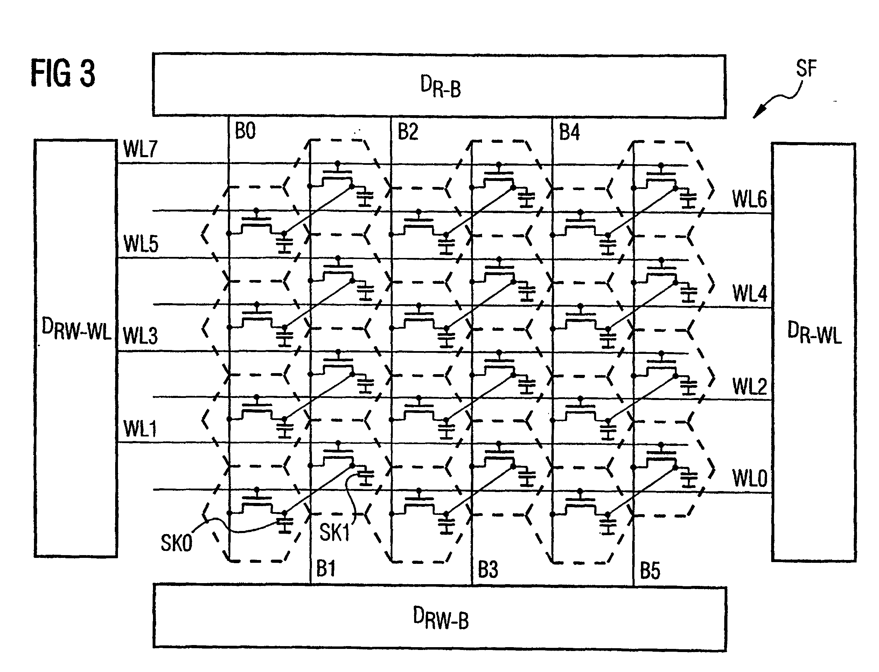

Figur 3 zeigt anhand eines vereinfachten Schaltbildes ein vorteilhaftes Ausführungsbeispiel eines DRAM-Halbleiterspeichers mit erfindungsgemäßen Dual-Port-Speicherzellen.

Bei einer herkömmlichen DRAM-Speicherzelle ist jeweils ein Auswahltransistor mit einem Speicherkondensator verbunden. Der besondere Vorteil bei der erfindungsgemäßen Speicherzelle liegt nun darin, daß jeweils zwei Kondensatoren des Speicherfeldes SF, zum Beispiel SK0, SK1, intern miteinander kurzgeschlossen sind. Dadurch entstehen Dual-Port-Speicherzellen DPS in einem Dual-Port DRAM-Halbleiterspeicher. Die beiden Ports sind dabei voneinander völlig unabhängig. Besonders vorteilhaft ist es, wenn die beiden Ports aufgetrennt sind in einen Schreib-/Lese-Port und in einen Refresh-Port, der nur für den Refresh bzw. das Wiederaufladen des Speicherfeldes SF zuständig ist. Die Dekoder für die Schreib-/Lese-Ports D_{RW-B}, D_{RW-WL} können dabei mit den ungeradzahligen, während die Dekoder für die Refresh-Ports D_{R-B}, D_{R-WL} mit den geradzahligen Daten-/Auswahlleitungen verbunden sein.

Die Speicherdichte bei einem derart ausgestaltetem Dual-Port DRAM-Halbleiterspeicher wird dadurch im Vergleich zu einem herkömmlichen Halbleiterspeicher zwar halbiert, ist allerdings immer noch um den Faktor 20 höher als bei einem herkömmlichen SRAM-Halbleiterspeicher. Ein derart ausgestalteter erfindungsgemäßer Dual-Port DRAM-Halbleiterspeicher kann einen herkömmlichen SRAM-Halbleiterspeicher mittlere Größe auf einem Chip mit Embedded DRAM-Speicherzellen sogar ersetzen. Bei all diesen Anwendungen ist sowohl die wesentlich höhere Speicherdichte eines als DRAM ausgestalteten Halbleiterspeichers im Vergleich zu einer 6-Transistorenspeicherzelle eines SRAM-Halbleiterspeichers und die damit verbundene niedrigere Verlustleistung von besonderem Vorteil.

Nachfolgend wird anhand von Figur 1 die Funktionsweise der erfindungsgemäßen Dual-Port-Speicherzelle DPS kurz beschrieben:

Während eines Schreibvorganges über die erste Datenleitung D1 wird der erste Auswahltransistor AT1 in den leitenden Zustand gesteuert. Das kapazitive Element KE wird dadurch mit dem Potential VDD - Vth geladen, wenn eine digitale "1" in die entsprechende Speicherzelle DPS geschrieben werden soll, oder wird auf das Potential VSS entladen, wenn beispielsweise eine digitale "0" in die entsprechende Speicherzelle DPS geschrieben werden soll.

Die Erfindung nutzt die Tatsache aus, daß für annähernd gleiche Potentiale am Gateanschluß und Sourceanschluß des Speichertransistors ST der Spannungsabfall UDS zwischen Sourceund Drain-Anschluß äquivalent zu dessen Einsatzspannung Vth ist. Da der Gateanschluß des Speichertransistors ST jedoch mit dem Versorgungspotential VDD verbunden ist, weisen der Source-Anschluß und Drain-Anschluß des Speichertransistors ST dasselbe Potential auf, d. h. VS = VD = VDD - Vth für eine digitale "1" und VS = VD = VSS für eine digitale "0". Da das Drainpotential VD und das Sourcepotential VS somit auf demselben Potential liegen, kann von jeder der Datenverarbeitungseinheiten auf die in dem Speichertransistor ST gespeicherte Information ohne Verringerung der Spannung in der Speicherzelle DPS zugegriffen werden.

Typischerweise sollte bei einer Dual-Port-Speicherzelle DPS bei einem Schreibvorgang maximal eine der angeschlossenen Datenverarbeitungseinheiten schreibberechtigt sein. Über eine einfache Logik-Schaltung läßt sich verhindern, daß die jeweils andere Datenverarbeitungseinheit gleichzeitig auf dieselbe Speicherzelle DPS schreiben kann. Umgekehrt ist es jedoch vorteilhafterweise möglich, daß beide an der Dual-Port-Speicherzelle angeschlossenen Datenverarbeitungseinheiten Daten aus dieser Speicherzelle DPS auslesen können.

Die Erfindung eignet sich insbesondere bei in CMOS-Technologie hergestellten Speicherzellen. Die Speicherzellen sind jedoch nicht auf eine bestimmte Transistortechnologie beschränkt, sondern können durch jede Art von feldeffektgesteuerten, selbstleitenden oder selbstsperrenden, typischerweise in MOS-Technologie hergestellten Transistoren realisiert werden. Denkbar wären jedoch auch bipolar ausgebildete Speicherzellen.

In einer Weiterbildung können selbstverständlich alle bekannten Maßnahmen nach dem Stand der Technik zur Flächenoptimierung sowie zur Verkürzung der Zugriffszeit, beispielsweise durch Optimierung der Designrules, angewendet werden, um die erfindungsgemäße Dual-Port DRAM-Speicherzelle DPS und somit den entsprechenden aus einer Vielzahl von solchen Speicherzellen aufgebauten Halbleiterspeicher weiterzubilden.

Figur 3 zeigt ein vorteilhaftes Ausführungsbeispiel eines Dual-Port-Halbleiterspeichers mit erfindungsgemäßen Dual-Port-Speicherzellen.

## Patentansprüche

1. Dual-Port Speicherzelle (DPS)
(a) mit einem ersten und zweiten Auswahltransistor (AT1, AT2),
(a1) deren Laststrecken in Reihe und zwischen einer ersten und einer zweiten Datenleitung (B1, B2) angeordnet sind und
(a2) deren Steueranschlusse jeweils mit einer ersten und einer zweiten Wortleitung (WL1, WL2) verbunden sind, wobei die Auswahltransistoren (AT1, AT2) über ihre Steueranschlüsse unabhängig voneinander ansteuerbar sind,
(b) mit einem kapazitivem Element (KE),
(b1) das einen ersten Ausgangsanschluß (D), der mit einem Laststreckenanschluß des ersten Auswahltransistor (AT1) verbunden ist, und einen vom ersten Ausgangsanschluß (D) unterschiedlichen zweiten Ausgangsanschluß (S), der mit einem Laststreckenanschluß des zweiten Auswahltransistor (AT2) verbunden, aufweist,
(b2) wobei an den Ausgangsanschlüssen (D, S) annähernd dasselbe Potential (V_{D}, V_{S}) anliegt,
wobei das kapazitive Element (KE) als Speichertransistor (ST) ausgebildet ist, dessen Laststrecke zwischen den in Reihe geschalteten Laststrecken der Auswahltransistoren (AT1, AT2) angeordnet ist und der über ein mit einem Versorgungspotential beaufschlagten Steueranschluß (G) steuerbar ist, und **dadurch gekennzeichnet,**
**dass** die Spannung (U_{DS}) über der Laststrecke des Speichertransistors (ST) dessen Einschaltspannung entspricht.

2. Dual-Port Speicherzelle nach Anspruch 1,
**dadurch gekennzeichnet,**
**dass** das kapazitive Element (KE) bzw. der Speichertransistor (ST) als CMOS-Transistor ausgebildet ist.

3. Dual-Port Speicherzelle nach einem der vorstehenden Ansprüche,
**dadurch gekennzeichnet,**
**dass** das kapazitive Element (KE) der Dual-Port Speicherzelle (DPS) uber den ersten und/oder über den zweiten Auswahltransistor (AT1, AT2) unabhängig voneinander sowohl beschreibbar als auch auslesbar ist.

4. Dual-Port Speicherzelle nach einem der vorstehenden Ansprüche,
**dadurch gekennzeichnet,**
**dass** mindestens eine Ladeeinrichtung (RS) vorgesehen ist, die jeweils über mindestens einen der Auswahltransistoren (AT1, AT2) die Kapazität des kapazitiven Elementes (KE) wiederaufladt.

5. Dual-Port Speicherzelle nach Anspruch 4,
**dadurch gekennzeichnet,**
**dass** einer der Auswahltransistoren (AT1, AT2) Bestandteil der Ladeeinrichtung (RS) ist.

6. Dual-Port Speicherzelle nach einem der Ansprüche 4 oder 5,
**dadurch gekennzeichnet,**
**dass** die Ladeeinrichtung (RS) Bestandteil eines Bitleitungsdekoders ist, der zumindest einen Leseverstärker und eine Voraufladeschaltung aufweist, und daß die Ladeeinrichtung (RS) einen taktgesteuerten Ringzähler aufweist, der über seinen Zählerstand in regelmaßigen Zeitabstanden eine Adresse für jeweils eine Speicherzelle generiert und über den die Ladeeinrichtung (RS) die Kapazität des kapazitiven Elements (KE) automatisch wiederauflädt.

7. Dual-Port Speicherzelle nach einem der vorstehenden Ansprüche,
**dadurch gekennzeichnet,**
**dass** die Datenleitungen (B1, B2) jeweils mit unterschiedlicher Taktfrequenz betrieben werden.

8. DRAM-Halbleiterspeicher mit einer Vielzahl von Dual-Port Speicherzellen (DPS) nach einem der vorstehenden Ansprüche.

## Claims

1. Dual-port memory cell (DPS)
(a) having a first and second select transistor (AT1, AT2),
(a1) whose load paths are arranged in series and between a first and a second data line (B1, B2), and
(a2) whose gates are connected to a first and a second word line (WL1, WL2) respectively, where the select transistors (AT1, AT2) can be driven independently of each other via their gates,
(b) having a capacitive element (KE),
(b1) which has a first output contact (D) which is connected to one load-path contact of the first select transistor (AT1), and a second output contact (S), different from the first output contact (D), which is connected to a load-path contact of the second select transistor (AT2),
(b2) where approximately the same potential (V_{D}, V_{S}) is applied to the output contacts (D, S),
the capacitive element (KE) being designed as storage transistor (ST), whose load path is arranged between the series-connected load paths of the select transistors (AT1, AT2) and which can be controlled via a gate (G) to which a supply potential is applied, and **characterized in that** the voltage (U_{DS}) across the load path of the storage transistor (ST) is equal to its threshold voltage.

2. Dual-port memory cell according to Claim 1,
**characterized in that**,
the capacitive element (KE) and/or the storage transistor (ST) is designed as a CMOS transistor.

3. Dual-port memory cell according to one of the preceding claims,
**characterized in that**
the capacitive element (KE) of the dual-port memory cell (DPS) can be both written to and read from independently of each other via the first and/or via the second select transistor (AT1, AT2).

4. Dual-port memory cell according to one of the preceding claims,
**characterized in that**
at least one charging device (RS) is provided, each of which recharges the capacitance of the capacitive element (KE) via at least one of the select transistors (AT1, AT2).

5. Dual-port memory cell according to Claim 4,
**characterized in that**
one of the select transistors (AT1, AT2) is part of the charging device (RS).

6. Dual-port memory cell according to one of Claims 4 or 5,
**characterized in that**
the charging device (RS) is part of a bit-line decoder having at least one sense amplifier and one precharging circuit, and **in that** the charging device (RS) has a clock-driven ring counter which generates at regular time intervals an address for one memory cell at a time via its count, and via which the charging device (RS) automatically recharges the capacitance of the capacitive element (KE).

7. Dual-port memory cell according to one of the preceding claims,
**characterized in that**
the data lines (B1, B2) are each driven with a different clock frequency.

8. DRAM semiconductor memory having a multiplicity of dual-port memory cells (DPS) according to one of the preceding claims.

## Revendications

1. Cellule de mémoire à deux ports (DSP)
(a) comportant des premier et second transistors de sélection (AT1,AT2),
(a1) dont les sections de charge sont montées en série et entre des première et seconde lignes de données (B1,B2), et
(a2) dont les bornes de commande sont reliées respectivement à des première et seconde lignes de mots (WL1,WL2), les transistors de sélection (AT1,AT2) pouvant être commandés au moyen de leurs bornes de commande, indépendamment l'un de l'autre,
(b) comportant un élément capacitif (KE),
(b1) qui comporte la première borne de sortie (D), qui est reliée à une borne de section de charge du premier transistor de sélection (AT1), et une seconde borne de sortie (S), qui diffère de la première borne de sortie (D) et est reliée à une borne de section de charge du second transistor de sélection (AT2),
(b2) approximativement le même potentiel (V_{D}, V_{S}) étant appliqué aux bornes de sortie (D,S),
dans lequel l'élément capacitif (KE) est agencé sous la forme d'un transistor de mémoire (ST), dont la section de charge est disposée entre les sections de charge, branchées en série, des transistors de sélection (AT1,AT2) et qui peut être commandée par l'intermédiaire d'une borne de commande (G) chargée par un potentiel d'alimentation,
**caractérisée en ce que** la tension (U_{D5}) aux bornes de la section de charge du transistor de mémoire (ST) correspond à la tension d'activation de ce transistor.

2. Cellule de mémoire à deux ports selon la revendication 1, **caractérisée en ce que** l'élément capacitif (KE) ou le transistor de mémoire (ST) est agencé sous la forme d'un transistor CMOS.

3. Cellule de mémoire à deux ports selon l'une des revendications précédentes, **caractérisée en ce qu'**aussi bien une écriture qu'une lecture peuvent être exécutées dans l'élément capacitif (KE) de la cellule de mémoire à deux ports (DPS) par l'intermédiaire du premier et/ou du second transistor de sélection (AT1,AT2), et ce indépendamment l'un de l'autre.

4. Cellule de mémoire à deux ports selon l'une des revendications précédentes, **caractérisé en ce qu'**il est prévu au moins un dispositif de charge (RS) qui recharge la capacité de l'élément capacitif (KE) respectivement par l'intermédiaire d'au moins l'un des transistors de sélection (AT1, AT2).

5. Cellule de mémoire à deux ports selon la revendication 4, **caractérisée en ce que** l'un des transistors de sélection (AT1,AT2) fait partie du dispositif de charge (RS).

6. Cellule de mémoire à deux ports selon l'une des revendications 4 ou 5, **caractérisée en ce que** le dispositif de charge (RS) fait partie d'un décodeur de lignes de bits, qui comporte au moins un amplificateur de lecture et un circuit de précharge, et que le dispositif de charge (RS) comporte un compteur en anneau commandé de façon cadencée, qui, au moyen de son état de comptage, génère, à des intervalles de temps réguliers, uneadresse pour une cellule de mémoire respective, et au moyen duquel le dispositif de charge (RS) recharge automatiquement la capacité de l'élément capacitif (KE).

7. Cellule de mémoire à deux ports selon l'une des revendications précédentes, **caractérisée en ce que** les canalisations de données (B1, B2) fonctionnent respectivement avec une fréquence de cadence différente.

8. Mémoire à semiconducteurs DRAM comportant une multiplicité de cellules de mémoire à deux ports (DPS) selon l'une des revendications précédentes.
